(19) **Europäisches Patentamt / European Patent Office / Office européen des brevets**

(11) **EP 4 664 160 A1**

(12) **DEMANDE DE BREVET EUROPEEN**

(43) Date de publication:
**17.12.2025 Bulletin 2025/51**

(21) Numéro de dépôt: **25181451.3**

(22) Date de dépôt: **06.06.2025**

(51) Classification Internationale des Brevets (IPC):
*G01V 3/08* *(2006.01)*

(52) Classification Coopérative des Brevets (CPC):
**G01V 3/08**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **10.06.2024 FR 2406090**

(71) Demandeur: **Commissariat à l'Energie Atomique et aux Energies Alternatives**
**75015 Paris (FR)**

(72) Inventeur: **VASSILEV, Andrea**
**38054 GRENOBLE (FR)**

(74) Mandataire: **Santarelli**
**Tour Trinity**
**1 bis Place de la Défense**
**92400 Courbevoie (FR)**

(54) **DÉTECTION D'ANOMALIES DANS UN ENVIRONNEMENT OU SYSTEME**

(57) L'invention concerne un dispositif et un procédé de détection d'anomalies au sein d'un environnement ou système, comportant les étapes suivantes :
- acquérir (E1) un signal normal ($S_N$) reflétant l'état normal de l'environnement ou du système,
- déterminer à partir du signal normal ($S_N$) une densité de probabilité *f* qui modélise un état de comportement normal de l'environnement ou du système,
- établir (E3) un filtre d'information en se basant sur ladite densité de probabilité *f*, ledit filtre d'information étant configuré pour converger vers une valeur limite *L* lorsqu'il est appliqué sur des échantillons d'un signal normal, tout en augmentant sa valeur en réponse à la détection d'une anomalie,
- établir (E4) une valeur seuil *S* basée sur ladite valeur limite de convergence,
- acquérir (E5) un signal courant ($S_C$) reflétant l'état de comportement courant de l'environnement ou du système,
- échantillonner (E6) ledit signal courant ($S_C$) en une série courante de N échantillons,
- calculer (E7) un résultat de l'application du filtre d'information sur ladite série courante de N échantillons,
- comparer (E8) ledit résultat avec ladite valeur seuil *S*, une anomalie étant détectée si ledit résultat excède ladite valeur seuil.

[Fig. 2]

FIG. 2

**Description**

**DOMAINE TECHNIQUE**

La présente invention se rapporte au domaine de la détection d'anomalies et, plus particulièrement, elle vise à identifier des comportements qui s'écartent d'un comportement standard ou ambiant.

**ÉTAT DE LA TECHNIQUE ANTÉRIEURE**

La détection d'anomalies englobe une diversité de techniques variées et trouve des applications dans de nombreux secteurs industriels.

Par exemple, la détection d'une cible ferromagnétique, qui induit une anomalie magnétique dans l'environnement, illustre l'une des nombreuses applications possibles de ces techniques. De nombreuses applications tirent parti du champ magnétique pour la détection, la localisation et le suivi d'objets, offrant des solutions précises dans des contextes visuellement exigeants.

Une telle méthode est décrite par Sheinker et al. dans l'article « Magnetic Anomaly Detection Using an Entropy Filter », publié dans Measurement Science and Technology, vol. 19, no 045205. Disponible en ligne : https://doi.org/10.1088/0957-0233/19/4/045205.

Cette méthode suggère de modéliser le comportement normal de l'environnement en utilisant une fonction de densité de probabilité continue, notée *f*. Une fenêtre glissante, $W_i$ qui contient N échantillons (où N est généralement égal à 30), est définie comme suit :

[Math. 1]

$$W_i = \{x_{i-N+1}, \quad x_{i-N+2}, \quad \dots, \quad x_{i-1}, x_i\}$$

Un pas de discrétisation , noté $\Delta$ est également établi. Par la suite, un filtre est appliqué à la fenêtre $W_i$ et il est calculé de la manière suivante :

[Math. 2]

$$M1(x_i) = -\sum_{x_k \in W_i} \Delta f(x_k) \log(\Delta f(x_k))$$

La présence d'une anomalie magnétique est détectée lorsque la valeur du filtre tombe en dessous d'un certain seuil *S* :

[Math. 3]

$$M1(x_i) < S$$

Le principal défi de cette méthode réside dans la difficulté à établir un seuil adéquat pour deux raisons principales. Premièrement, la valeur optimale du seuil n'est pas connue a priori. Deuxièmement, le seuil est influencé à la fois par la longueur de la fenêtre glissante, N, et le degré de discrétisation, $\Delta$.

En particulier, il est crucial de souligner que le choix approprié de $\Delta$ est déterminant pour l'efficacité du détecteur. Prenons pour exemple une valeur de $\Delta$ surdimensionnée: cela pourrait conduire le filtre à réagir de manière contre-intuitive, en augmentant au lieu de diminuer en présence d'une anomalie, et dans ce cas, l'anomalie n'est jamais détectée.

Une autre méthode a été décrite par Zhou et al. dans l'article intitulé « Magnetic anomaly detection via a combination approach of minimum entropy and gradient orthogonal functions », paru dans ISA Transactions, volume 134, pages 548-560. Disponible en ligne : https://doi.org/10.1016/j.isatra.2022.08.026.

La méthode de Zhou utilise la même approche que Sheinker, et définit un filtre de la manière suivante :

[Math. 4]

$$M2(x_i) = -\sum_{x_k \in W_i} f(x_k)\log(f(x_k))$$

La présence d'une anomalie magnétique est détectée lorsque la valeur du filtre tombe en dessous d'un certain seuil S :

[Math. 5]

$$M2(x_i) < S$$

La méthode proposée par Zhou offre l'avantage de s'affranchir de la nécessité d'un pas de discrétisation $\Delta$ pour le traitement du signal. Cependant, à l'instar de l'approche précédente, la détermination d'un seuil adéquat s'avère complexe, car sa valeur optimale n'est pas connue a priori et elle est également affectée par la dimension de la fenêtre glissante N. L'ajustement du seuil en fonction de la longueur de la fenêtre glissante s'avère particulièrement fastidieux, étant donné que la taille de la fenêtre peut varier. En conséquence, les méthodes traditionnelles requièrent souvent un fastidieux processus d'essais et d'erreurs pour déterminer le seuil approprié.

L'objet de la présente invention est de proposer un dispositif et un procédé de détection d'anomalies remédiant aux inconvénients précités, en simplifiant notablement la définition du seuil de détection.

## EXPOSÉ DE L'INVENTION

Cet objectif est atteint avec un procédé de détection d'anomalies au sein d'un environnement ou système, comportant les étapes suivantes :

- acquérir un signal normal reflétant l'état normal de l'environnement ou du système,
- déterminer à partir dudit signal normal, une densité de probabilité, notée f, qui modélise un état de comportement normal de l'environnement ou du système,
- établir un filtre d'information en se basant sur ladite densité de probabilité, ledit filtre d'information étant configuré pour converger vers une valeur limite lorsqu'il est appliqué sur des échantillons d'un signal normal, tout en augmentant sa valeur en réponse à la détection d'une anomalie,
- établir une valeur seuil basée sur ladite valeur limite de convergence,
- acquérir un signal courant reflétant l'état de comportement courant de l'environnement ou du système,
- échantillonner ledit signal courant en une série courante de N échantillons en utilisant une fenêtre glissante Wi déterminée,
- calculer un résultat de l'application du filtre d'information sur ladite série courante de N échantillons,
- comparer ledit résultat avec ladite valeur seuil, une anomalie étant détectée si ledit résultat excède ladite valeur seuil.

Ce procédé améliore notablement la détection des anomalies, garantissant une haute fiabilité, tout en étant extrêmement simple à implémenter. En effet, la détermination du seuil est intuitive et s'effectue aisément, car elle se base sur la valeur limite qui est intrinsèquement définie.

Avantageusement, ladite valeur seuil est égale à ladite valeur limite de convergence, majorée d'une valeur de majoration choisie en fonction d'un compromis recherché entre une détection fiable et une minimisation du nombre de fausses alarmes.

Cela facilite la sélection simplifiée du seuil de détection en fonction du degré de précision et de fiabilité souhaité pour l'identification d'anomalies.

Selon un premier mode de réalisation, le filtre d'information correspond à un premier filtre $I_i$ conçu de telle sorte que, lorsqu'il est appliqué sur des échantillons d'un signal normal, il converge vers une valeur limite qui correspond à l'entropie de la densité de probabilité associée à ce signal normal.

Ce premier filtre assure l'établissement automatique de l'entropie de la densité de probabilité associée au signal normal en tant que borne inférieure pour le seuil.

Avantageusement, l'application dudit premier filtre $I_i$ sur ladite série courante d'un nombre déterminé $N$ d'échantillons consiste à calculer le logarithme naturel de la valeur de la densité de probabilité $f$ pour chacun des échantillons $x_k$, à faire ensuite la sommation de ces logarithmes, et à multiplier le résultat de cette sommation par le facteur négatif correspondant à l'inverse dudit nombre déterminé $N$ d'échantillons, selon la formule suivante :

[Math. 6]

$$I_i = -\frac{1}{N} \sum_{x_k \in W_i} \log f(x_k)$$

Avantageusement, ladite valeur seuil *S* est égale à la valeur de l'entropie *H(f)* de la densité de probabilité *f*, majorée d'une valeur $\varepsilon$ comprise dans un intervalle allant de 1% à 20% de la valeur absolue de ladite entropie, selon la formule suivante :

[Math. 7]

$$S = H(f) + \varepsilon$$

La valeur ajoutée choisie pour la majoration est soigneusement déterminée afin d'atteindre un équilibre optimal entre la capacité à détecter de manière fiable les anomalies réelles et la minimisation du risque de générer des alertes incorrectes, soit des fausses alarmes.

Selon un premier exemple, ladite valeur de majoration est définie dans une fourchette comprise entre 10% et 20% de la valeur absolue de l'entropie, dans le but de parvenir à une probabilité très faible de fausses alarmes, comprise entre $10^{-4}$ et $10^{-3}$.

Selon un deuxième exemple, ladite valeur de majoration est définie dans une fourchette comprise entre 1% et 10% de la valeur absolue de l'entropie, pour favoriser la probabilité de bonne détection.

Selon un deuxième mode de réalisation, le filtre d'information correspond à un deuxième filtre $K_i$ qui s'appuie sur ledit premier filtre décrit précédemment, et utilise une fonction continue, notée g, qui représente une approximation de la densité de probabilité de données du signal courant $S_C$ sur une fenêtre glissante $W_i$ prédéterminée.

L'application dudit deuxième filtre $K_i$ sur ladite série courante d'un nombre déterminé N d'échantillons consiste à calculer le logarithme naturel de la valeur de la fonction continue *g* pour chacun des échantillons, calculer la moyenne des résultats obtenus pour ces logarithmes naturels, et d'ajouter le résultat de ladite moyenne au résultat de l'application du premier filtre $I_i$ sur la même série courante d'échantillons, selon la formule suivante :

[Math. 8]

$$K_i = \frac{1}{N} \sum_{x_k \in W_i} \log g(x_k) + I_i$$

L'invention vise également un dispositif de détection d'anomalies au sein d'un environnement ou système, comportant :

- un module d'acquisition configuré pour acquérir un signal courant reflétant l'état de comportement courant de l'environnement ou du système,
- un processeur configuré pour :
- échantillonner ledit signal courant en une série courante de N échantillons en utilisant une fenêtre glissante Wi déterminée,
- calculer un résultat de l'application d'un filtre d'information sur ladite série courante de N échantillons, ledit filtre d'information étant basé sur une densité de probabilité modélisant un état de comportement normal de l'environnement ou du système, ledit filtre d'information étant configuré pour converger vers une valeur limite lorsqu'il est appliqué sur des échantillons d'un signal normal, tout en augmentant sa valeur en réponse à la détection d'une anomalie,
- comparer ledit résultat avec une valeur seuil basée sur ladite valeur limite de convergence, une anomalie étant détectée si ledit résultat excède ladite valeur seuil, et
- une interface de sortie configuré pour indiquer la détection d'une anomalie.

Selon une première application, le dispositif comporte un magnétomètre configuré pour générer ledit signal courant en captant un champ magnétique ambiant, comprenant le champ terrestre ainsi que diverses perturbations magnétiques.

Selon une deuxième application, le dispositif comporte un accéléromètre (ou un capteur de vibrations) configuré pour générer le signal courant en captant les vibrations émanant d'une machine à surveiller.

Selon une troisième application, le dispositif comporte un compteur configuré pour générer le signal courant en mesurant le volume de données échangées au niveau d'un nœud spécifique d'un réseau informatique à surveiller.

Selon une quatrième application, le dispositif comporte une sonde à courant de Foucault configurée pour produire le signal courant en mesurant l'épaisseur d'un pipeline sous surveillance.

## BRÈVE DESCRIPTION DES DESSINS

La présente invention sera mieux comprise à la lecture de la description d'exemples de réalisation donnés à titre purement indicatif et nullement limitatif, en faisant référence aux dessins annexés sur lesquels :

La [Fig. 1] illustre de manière schématique un dispositif de détection d'anomalies au sein d'un environnement ou système technique, selon un mode de réalisation de l'invention ;

La [Fig. 2] illustre de manière schématique un procédé de détection d'anomalies au sein d'un environnement ou système technique, selon un mode de réalisation de l'invention ;

La [Fig. 3] illustre de manière schématique un procédé de détection d'anomalies au sein d'un environnement ou système technique, selon un premier mode de réalisation préféré de l'invention ;

Les [Fig. 4A], [Fig. 4B] et [Fig. 5A], [Fig. 5B], [Fig. 5C], [Fig. 5D], [Fig. 5E], [Fig. 5F] montrent l'application de la présente invention dans la détection d'anomalies en exploitant les données recueillies par un capteur, selon une implémentation spécifique de l'invention ; et

La [Fig. 6] illustre de manière schématique un procédé de détection d'anomalies au sein d'un environnement ou système technique, selon un premier mode de réalisation préféré de l'invention.

## EXPOSÉ DÉTAILLÉ DE MODES DE RÉALISATION PARTICULIERS

Le concept à la base de l'invention est de proposer une technique de détection où le seuil est déterminé de manière intuitive à partir d'une valeur prédéfinie et connue à l'avance.

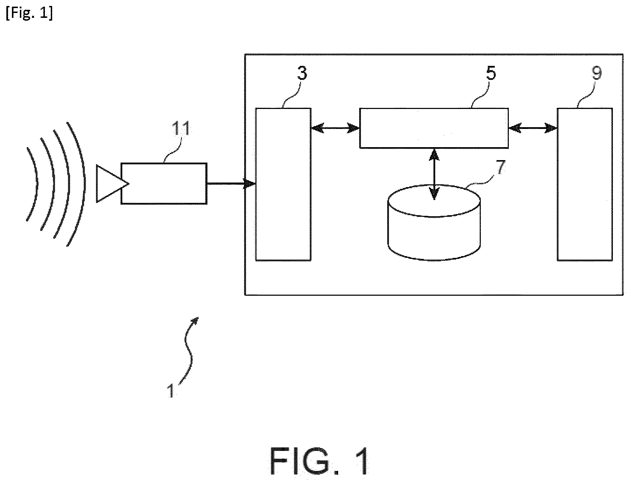

La Fig. 1 illustre de manière schématique un dispositif de détection d'anomalies au sein d'un environnement ou système technique, selon un mode de réalisation de l'invention.

Le dispositif 1 de détection d'anomalies comporte un module d'acquisition 3, un processeur 5 pouvant être un microcontrôleur, un processeur central ou un microprocesseur, une mémoire 7 dédiée, ainsi que des interfaces 9 d'entrées/sorties.

Le dispositif 1 de détection est adapté pour acquérir des signaux qui peuvent être de nature différente en fonction du problème considéré. Par exemple, il peut capter des signaux magnétiques via un magnétomètre pour identifier des cibles ferromagnétiques, des signaux de vibration en provenance d'un capteur de vibrations pour le suivi de l'état d'une machine, ou encore des signaux acoustiques pour contrôler l'intégrité d'un pipeline, parmi d'autres applications. En conséquence, le dispositif 1 est conçu pour être équipé ou associé avec un capteur 11 adéquat, selon les spécificités de l'application visée.

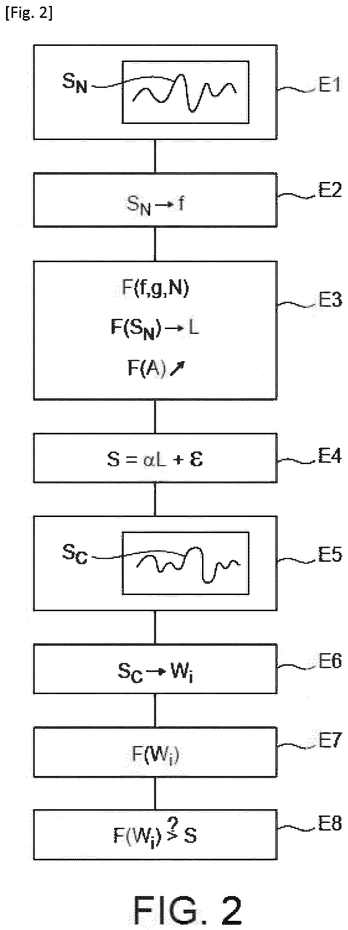

Le dispositif 1 de détection est spécifiquement conçu pour implémenter un procédé de détection détaillée dans le schéma de la Fig. 2.

En effet, la Fig. 2 illustre de manière schématique un procédé de détection d'anomalies au sein d'un environnement ou système technique, selon un mode de réalisation de l'invention.

Le procédé s'articule autour de deux phases : une phase initiale de calibration, décrite par les étapes E1 à E4, et une phase opérationnelle, consacrée à la détection active d'anomalies, détaillée dans les étapes E5 à E8.

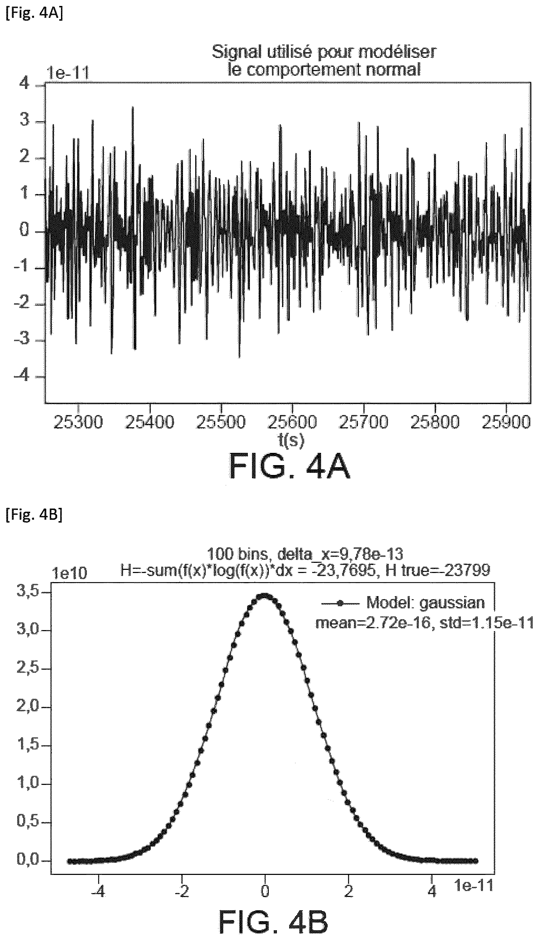

A l'étape E1, le module d'acquisition 3 est configuré pour acquérir un signal normal $S_N$ reflétant l'état normal de l'environnement ou du système. Un exemple est représenté par le signal temporel dans le graphique de la Fig. 4A.

A l'étape E2, le processeur 5 est configuré pour déterminer une densité de probabilité, notée $f$, qui modélise un état de comportement normal de l'environnement ou du système étudié. Un exemple de densité de probabilité est donnée dans le graphique de la Fig. 4B.

A l'étape E3, le processeur 5 est configuré pour établir un filtre d'information $F$ en se basant sur la densité de probabilité $f$. Le filtre d'information $F$ est établi en prenant en compte la densité de probabilité $f$ ainsi que la taille de la fenêtre $N$. Il peut également intégrer une fonction continue $g$ construit à partir d'un signal courant. (Pour l'inventeur : ici, le filtre d'information 'F' est un filtre qui généralise les deux filtres 'li' et 'Ki'. De plus, sans cette généralisation, nous serions confrontés à une objection liée à l'absence d'unité d'invention).

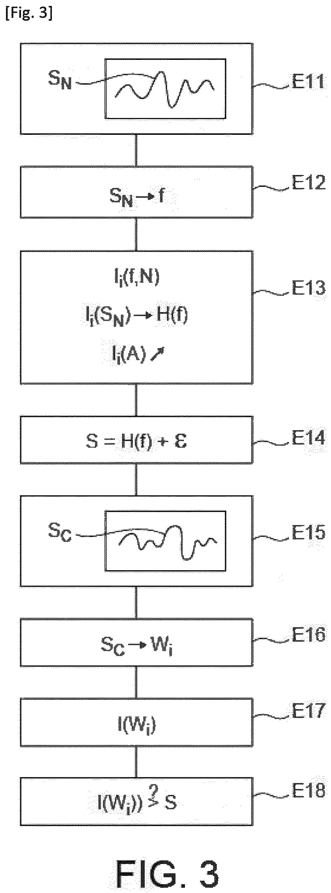

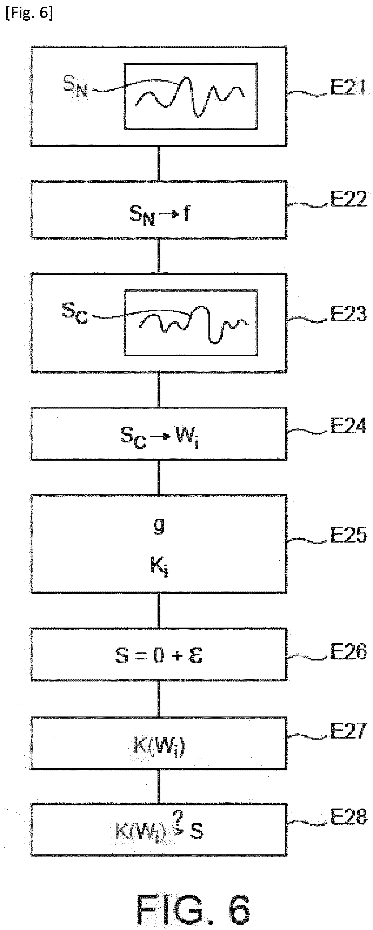

Le filtre d'information $F(x_k)$ converge vers une valeur limite prédéfinie $L$ lorsqu'il est appliqué sur des échantillons d'un signal normal $S_N$. Ainsi, il suffit d'utiliser des échantillons d'un signal normal $S_N$ pour déterminer cette valeur limite $L$. Selon l'exemple d'un premier mode de réalisation, expliquée en lien avec la Fig. 3, la valeur limite $L$ correspond à l'entropie de la densité de probabilité caractérisant l'état normal du système ou de l'environnement. Selon l'exemple d'un deuxième mode de réalisation décrit en relation avec la Fig. 6, la valeur limite $L$ correspond à zéro. De plus, le filtre d'information $F(x_k)$

est caractérisé par une augmentation de sa valeur en réponse à la détection d'une anomalie 'A'.

A l'étape E4, le processeur 5 est configuré pour établir une valeur seuil $S$ basée sur la valeur limite $L$ de convergence. Etant donné que le filtre d'information $F(x_k)$ tend naturellement vers une valeur limite $L$ bien déterminée lorsqu'il analyse un signal normal $S_N$, et qu'en revanche il présente une augmentation en cas d'anomalie, la définition de la valeur seuil S devient intuitive : elle s'établit un peu au-dessus de $L$ pour qu'en exploitation, toute valeur du filtre surpassant $S$ signale une anomalie. A titre illustratif, on peut modéliser le seuil $S$ comme une fonction affine de $L$, suivant l'équation $S = \alpha L + \varepsilon$, où $\alpha$ est un facteur d'ajustement positif ou nul et $\varepsilon$ une petite valeur de majoration constante positive, assurant une marge au-dessus de la valeur limite $L$ pour la détection fiable des anomalies.

Avantageusement, la valeur seuil S peut tout simplement être égale à la valeur limite $L$, majorée de la valeur de majoration constante $\varepsilon$. Cette valeur de majoration $\varepsilon$ est choisie en fonction d'un compromis recherché entre une détection fiable et une minimisation du nombre de fausses alarmes.

Au sein du dispositif 1 de détection, la mémoire 7 stocke la fonction de densité de probabilité $f$, le filtre d'information $F$, la valeur limite $L$ de convergence ainsi que la valeur du seuil $S$ pour un rappel efficace lors des opérations de détection.

Les étapes E1 à E4 définissent la phase de calibration initiale qui, une fois complétée, n'exige pas d'être répétée à chaque nouvelle séquence de détection d'anomalies.

La détection active d'anomalies débute à l'étape E5, durant laquelle le processeur 5 est configuré pour acquérir un signal courant $S_C$ reflétant l'état de comportement courant de l'environnement ou du système à surveiller.

A l'étape E6, le processeur 5 est configuré pour échantillonner le signal courant $S_C$ en une série initiale de N échantillons en utilisant une fenêtre glissante Wi déterminée.

Il convient de souligner que la dimension de la fenêtre sélectionnée est modulable. Cette capacité à ajuster la taille de la fenêtre s'explique par le fait que, selon la présente invention, la valeur seuil $S$ n'est pas liée à la dimension de la fenêtre adoptée. La même valeur seuil $S$ est appliquée, ce qui garantit l'uniformité du critère de détection.

A l'étape E7, le processeur 5 est configuré pour calculer un résultat $F(W_i)$ de l'application du filtre d'information sur la série courante $S_C$ de N échantillons.

A l'étape E8, le processeur 5 est configuré pour comparer ce résultat $F(W_i)$ avec la valeur seuil $S$. Une anomalie est détectée si le résultat $F(W_i)$ excède la valeur seuil $S$. La détection d'une anomalie peut être signalée par l'interface de sortie 9 du dispositif 1 de détection.

La Fig. 3 illustre de manière schématique un procédé de détection d'anomalies au sein d'un environnement ou système technique, selon un premier mode de réalisation préféré de l'invention.

Afin de clarifier la présentation de ce procédé, il est expliqué en se référant aux exemples illustrés par les figures 4A à 5F.

Les Figs. 4A à 5F démontrent l'application de la présente invention dans la détection d'anomalies en exploitant les données recueillies par un capteur, selon une implémentation spécifique.

Selon cet exemple, le dispositif 1 de détection est associé à un magnétomètre 11 configuré pour générer le signal courant en captant un champ magnétique ambiant, comprenant le champ terrestre ainsi que diverses perturbations magnétiques. Le magnétomètre 11 est par exemple positionné à la surface terrestre afin de capter les variations du champ magnétique local. Le signal enregistré reflète le champ magnétique terrestre naturel, tout en incluant diverses interférences et bruits parasites, tels que le bruit propre au magnétomètre 11 et les perturbations géomagnétiques extérieures.

La Figure 4A illustre le profil standard du champ magnétique tel que mesuré en l'absence d'interférences. En introduisant dans cet environnement un objet ferromagnétique, tel qu'un véhicule, le magnétomètre 11 captera des variations superposées au signal de base. Ces variations ou perturbations sont qualifiées d'anomalies. L'objectif principal du dispositif 1 de détection est de repérer avec précision de telles anomalies.

Conformément à ce qui a été précédemment établi, la phase de calibration, qui s'étend des étapes E11 à E14, est dédiée à définir la fonction de densité de probabilité, le filtre d'information, la valeur limite de convergence ainsi que la valeur du seuil.

A l'étape E11, le module d'acquisition 3 est configuré pour acquérir un signal normal $S_N$ reflétant l'état normal de l'environnement ou du système.

Un tel signal $S_N$ est illustré sur la Fig. 4A. Cette figure expose plus précisément un graphique du signal magnétique enregistré pendant une période de 1000 minutes qui sert de base pour établir le modèle standard du comportement du champ magnétique local.

A l'étape E12, le processeur 5 est configuré pour déterminer la densité de probabilité f qui modélise l'état de comportement normal de l'environnement ou du système étudié.

A titre d'exemple, la Fig. 4B montre un diagramme qui représente une densité de probabilité $f$ de type gaussienne. La fonction $f$ est construite en calculant la moyenne et la variance à partir du signal normal représenté sur la Fig. 4A. Ces calculs s'appuient sur les formules suivantes :

[Math. 9]

$$\mu = \frac{1}{N}\sum_{x_k \in W_i} x_k \quad \text{et} \quad \sigma^2 = \frac{1}{N}\sum_{x_k \in W_i}(x_k - \mu)^2$$

Sur la base de ces paramètres, la densité de probabilité *f* peut être exprimée comme suit :

[Math. 10]

$$f(x_k) = \frac{1}{\sqrt{2\pi\sigma^2}} exp\left[-\frac{(x_k - \mu)^2}{2\sigma^2}\right]$$

Considérons, par exemple, le signal normal du champ magnétique terrestre, observé sur une période de 1000 minutes comme illustré dans la Figure 4A. Pour ce signal, il a été déterminé que la moyenne est $\mu = 2.72 \times 10^{-16}$ et l'écart type $\sigma = 1.15 \times 10^{-11}$.

On notera que la fonction *f* de densité de probabilité représentant le comportement normal d'un signal peut être représentée soit par une fonction continue, soit par un histogramme, en fonction de la nature spécifique du signal étudié.

A l'étape E13, le processeur 5 est configuré pour établir un filtre d'information moyenne $I_i$, nommé 'premier filtre', qui s'appuie sur la fonction de densité de probabilité *f*. Ce premier filtre est conçu de telle sorte que, lorsqu'il est appliqué sur un signal normal $S_N$, il converge vers une valeur limite qui correspond à l'entropie de la densité de probabilité *f* associée à ce signal normal.

Le premier filtre sur une série initiale ou une série courante d'un nombre déterminé N d'échantillons consiste à calculer le logarithme naturel de la valeur de la densité de probabilité *f* pour chacun des échantillons $x_k$ dans l'ensemble de N échantillons. La somme de ces logarithmes est ensuite obtenue, et le total est multiplié par l'opposé de l'inverse du nombre N d'échantillons, selon la formule suivante :

[Math. 11]

$$I_i(x_k) = -\frac{1}{N}\sum_{x_k \in W_i} \log f(x_k)$$

La valeur à laquelle tend la sortie du premier filtre, lorsque le nombre d'échantillons du signal normal $S_N$ augmente indéfiniment, correspond à l'entropie de la densité de probabilité, désignée par *H(f)*. Cette relation est décrite par la formule suivante :

[Math. 12]

$$I_i \xrightarrow[N\to\infty]{} H(f) = -\int_{x \in X} f(x) * \log\big(f(x)\big)\,dx$$

où *X* correspond à l'ensemble des valeurs possibles pour *x*.

A l'étape E14, le processeur 5 est configuré pour établir la valeur seuil S basée sur la valeur *H(f)* de l'entropie de la densité de probabilité *f* associée au signal normal $S_N$.

Avantageusement, la valeur seuil S est égale à la valeur de l'entropie *H(f)* de la densité de probabilité *f*, majorée d'une valeur $\varepsilon$ comprise dans un intervalle allant de 1% à 20% de la valeur absolue de l'entropie *H(f)*, selon la formule suivante :

[Math. 13]

$$S = H(f) + \varepsilon$$

Ainsi, le choix du seuil *S* est bien très simple à faire ; il suffit de calculer l'entropie *H(f)* de la densité de probabilité *f*, et de prendre comme valeur de seuil, cette entropie plus une petite valeur $\varepsilon$.

Il est à souligner que relever la valeur de majoration $\varepsilon$ réduit le nombre de fausses alarmes, mais cela peut aussi réduire la sensibilité et la fiabilité de détection. Inversement, en abaissant la valeur de majoration $\varepsilon$, la fiabilité s'améliore grâce à une meilleure sensibilité, au prix cependant d'une augmentation des fausses alarmes. Par conséquent, le réglage de cette valeur $\varepsilon$ peut être réalisé selon un équilibre entre le taux de détection correcte et le risque de fausses alertes, en fonction des exigences spécifiques à chaque application.

Selon un premier exemple, la valeur de majoration $\varepsilon$ est définie dans une fourchette comprise entre 10% et 20% de la valeur absolue de l'entropie, dans le but de parvenir à une probabilité très faible de fausses alarmes, comprise entre $10^{-4}$ et $10^{-3}$.

Selon un autre exemple, la valeur de majoration est définie dans une fourchette comprise entre 1% et 10% de la valeur absolue de l'entropie, pour favoriser l'atteinte d'une fiabilité maximale dans la détection d'anomalie.

A des fins d'illustration, prenons l'entropie $H(f)$ calculée pour la densité de probabilité $f$ affichée dans la Fig. 4B, qui s'établit à $H(f) = -23.77$. Dans l'optique de favoriser la sensibilité de la détection tout en acceptant un taux plus élevé de fausses alertes, il est possible d'adopter une valeur de seuil $\varepsilon$ volontairement faible. En fixant $\varepsilon$ à 1.47, soit approximativement 6% de la valeur absolue de $H(f)$, on établit le seuil de détection $S$ à -22.3, ce qui se traduit par la somme de $H(f)$ et $\varepsilon$, soit $S = -23.77 + 1.47 = -22.3$.

Les étapes E11 à E14 sont dédiées à la phase de calibration initiale. Une fois cette phase complétée, la détection opérationnelle d'anomalies est lancée, commençant à l'étape E15.

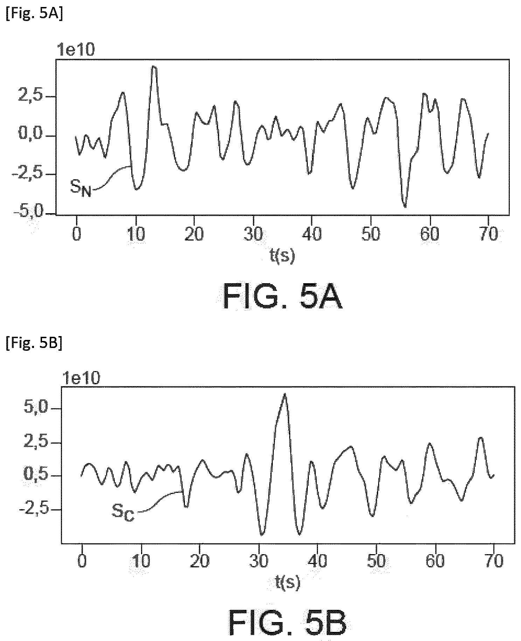

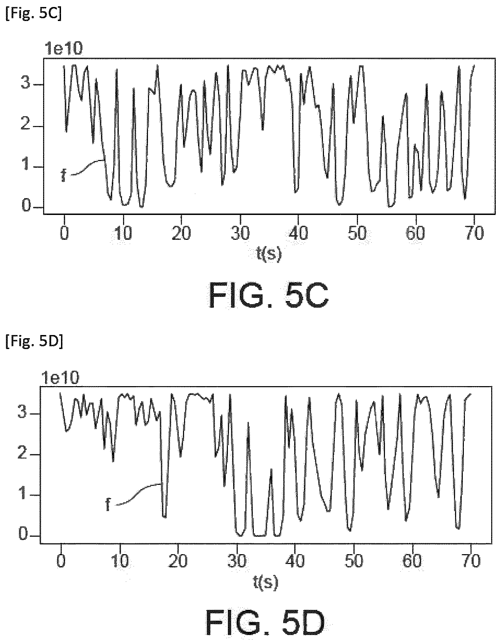

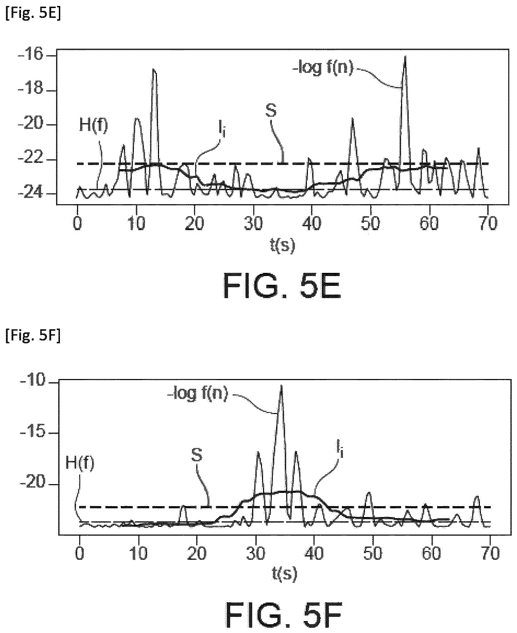

La suite de la description est poursuivie à travers les figures 5A à 5F, qui se basent sur le même cas d'étude que celui des figures 4A et 4B. Les figures 5A, 5C et 5E illustrent les résultats obtenus pour un signal considéré comme normal. En parallèle, les figures 5B, 5D et 5F montrent les données correspondant à une situation 'anormale', tel que la présence d'un véhicule à proximité du capteur. Plus précisément, les figures 5A et 5B exposent respectivement les enregistrements d'un signal normal $S_N$ et d'un signal courant $S_C$ affecté par une anomalie. Les figures 5C et 5D dévoilent les profils de densité de probabilité associés aux données des figures 5A et 5B, respectivement. Enfin, les figures 5E et 5F comparent les résultats du filtre des données des figures 5A et 5B avec la valeur de seuil établie, mettant ainsi en lumière la présence ou l'absence d'anomalies. Les valeurs de l'entropie $H(f) = -23.77$ et de la valeur seuil $S = -22.3$ sont matérialisées par les droites horizontales dans les figures 5E et 5F.

A l'étape E15, le processeur 5 est configuré pour acquérir un signal courant $S_C$ reflétant l'état de comportement courant de l'environnement ou du système à surveiller. Ce signal courant $S_C$ est représenté sur la Fig. 5A dans le cas où c'est un signal normal ne présentant pas d'anomalies, ou sur la Fig. 5B s'il comportait des anomalies.

A l'étape E16, le processeur 5 est configuré pour échantillonner le signal courant $S_C$ en une série de N échantillons en utilisant une fenêtre glissante Wi déterminée.

[Math. 1]

$$W_i = \{x_{i-N+1}, \qquad x_{i-N+2}, \qquad \ldots, \qquad x_{i-1}, x_i\}$$

A l'étape E17, le processeur 5 est configuré pour calculer le résultat $I(W_i)$ de l'application du premier filtre d'information sur la série courante de N échantillons. En effet, le processeur 5 évalue d'abord la densité de probabilité $f$ pour les données $x_k$ issues du signal courant $S_C$ illustrée dans la Fig. 5B. La courbe $f(x_k)$ qui représente cette densité de probabilité en fonction du temps est illustrée dans la Fig. 5D. Le processeur 5 est configuré ensuite pour calculer $-logf(x_k)$, donnant lieu à la courbe correspondante représentée sur la Fig. 5F. Finalement, le processeur 5 effectue la sommation des logarithmes de $f(x_k)$ pour $N$ d'échantillons, avec $N = 30$ dans ce contexte. Cette somme est ensuite multipliée par l'opposé de l'inverse de $N$, conformément à la formule énoncée antérieurement. Le résultat du filtre $I_i \equiv I(W_i)$ est présenté sous forme de courbe temporelle dans la Fig. 5F.

A l'étape E18, le processeur 5 est configuré pour comparer ce résultat $I(W_i)$ avec la valeur seuil $S$. Une anomalie est détectée si le résultat $I(W_i)$ excède la valeur seuil $S$:

[Math. 14]

$$I(W_i) > S$$

La Fig. 5E illustre que, pour un signal normal $S_N$, la courbe temporelle correspondant au filtre $I(W_i)$ demeure systématiquement en deçà de la valeur seuil fixée à $S = -22.3$. En contraste, la Fig. 5F révèle des intervalles où la courbe temporelle du filtre $I(W_i)$ associée au signal courant $S_C$ s'élève au-dessus de cette valeur seuil. Ce dépassement signale la présence d'une anomalie.

La Fig. 6 illustre de manière schématique un procédé de détection d'anomalies au sein d'un environnement ou système technique, selon un deuxième mode de réalisation préféré de l'invention.

Ce procédé se distingue de celle présentée dans la Figure 3 principalement par l'introduction d'un filtre, distinct du premier filtre. Selon ce deuxième mode de réalisation, le filtre d'information correspond à un deuxième filtre qui s'appuie sur le premier filtre décrit dans la Fig. 3.

A l'étape E21, le module d'acquisition 3 est configuré pour acquérir un signal normal $S_N$ reflétant l'état normal de l'environnement ou du système.

A l'étape E22, le processeur 5 est configuré pour déterminer à partir du signal normal $S_N$ la densité de probabilité $f$ qui modélise l'état de comportement normal de l'environnement ou du système étudié.

A l'étape E23, le processeur 5 est configuré pour acquérir un signal courant $S_C$ reflétant l'état de comportement courant de l'environnement ou du système à surveiller.

A l'étape E24, le processeur 5 est configuré pour échantillonner le signal courant $S_C$ afin d'obtenir une série de N échantillons, ceci à l'aide d'une fenêtre glissante prédéfinie Wi.

[Math. 1]

$$W_i = \left\{ x_{i-N+1}, \qquad x_{i-N+2}, \qquad \dots , \qquad x_{i-1,} \, x_i \right\}$$

A l'étape E25, le processeur 5 est configuré pour approximer la densité de probabilité des données du signal courant $S_C$ sur cette fenêtre glissante $W_i$ par une densité de probabilité continue $g$. L'estimation de la densité de probabilité $g$ peut être effectuée à l'aide d'un histogramme ou par l'approche non-paramétrique d'estimation par noyau, aussi connue sous le nom d'Estimation de Densité par Noyau (Kernel Density Estimation, KDE). La KDE utilise des fonctions appelées noyaux pour attribuer des poids locaux, et permet d'obtenir un lissage des données émanant d'un ensemble fini d'échantillons. Cette technique est particulièrement utile lorsque le nombre d'échantillons $N$ est limité.

Selon ce deuxième mode de réalisation, l'application du deuxième filtre, désigné $K_i$, sur une série initiale de calibration ou une série courante d'un nombre déterminé N d'échantillons par le processeur 5 consiste à calculer d'abord le logarithme naturel de la valeur de la fonction continue $g$ pour chacun des échantillons. Ensuite, le processeur 5 procède à calculer la moyenne arithmétique des résultats obtenus pour ces logarithmes naturels. Cette moyenne est par la suite ajoutée au résultat de l'application du premier filtre sur la même série d'échantillons. La formule employée par le processeur 5 est la suivante :

[Math. 8]

$$K_i = \frac{1}{N} \sum_{x_k \in W_i} \log g(x_k) + I_i$$

Lorsque ce deuxième filtre est appliqué sur les échantillons du signal normal $S_N$, sa valeur converge vers zéro. De plus, la valeur du deuxième filtre croît en présence d'une anomalie, comme cela a été le cas pour le premier mode de réalisation.

A l'étape E26, le processeur 5 est configuré pour établir la valeur seuil $S$ qui s'exprime tout simplement selon la formule suivante :

[Math. 15]

$$S = 0 + \varepsilon$$

Par conséquent, la détermination du seuil $S$ est encore plus simple que dans le premier mode de réalisation. Il n'est pas nécessaire de calculer l'entropie $H(f)$ puisqu'il suffit de prendre une petite valeur fixe $\varepsilon$. Cette dernière est toujours à régler en fonction d'un compromis entre la probabilité de détection correcte et la probabilité de fausse alarme.

A l'étape E27, le processeur 5 est configuré pour calculer la valeur $K_i \equiv K(W_i)$ qui résulte de l'application du deuxième filtre d'information sur la série courante de N échantillons.

Enfin, à l'étape E28, le processeur 5 est configuré pour comparer la valeur $K(W_i)$ précédemment obtenue avec le seuil $S$. La détection d'une anomalie est confirmée si $K(W_i)$ dépasse la valeur seuil $S$ :

[Math. 16]

$$K(W_i) \; > S$$

Il convient de noter que la présente invention, illustrée par un exemple détaillé associé aux figures 4A-4B et 5A-5F pour un cas d'application impliquant un signal magnétique et la détection d'un objet ferromagnétique, est adaptée pour être mise en œuvre dans d'autres applications.

Un premier exemple d'application est la détection d'attaques dans un réseau informatique. Pour cette situation, une série temporelle pertinente, notée Xt,T (où 't' fait référence au temps), recense la quantité de données mesurée en octets ou en bits transitant par un nœud du réseau sur l'intervalle de temps [t ; t+T]. Le capteur utilisé est alors un compteur configuré pour générer le signal courant par la mesure du volume de données échangées au niveau d'un nœud spécifique du réseau informatique que l'on souhaite surveiller.

Un deuxième exemple concerne la détection d'anomalies dans les machines. Pour cet usage, le capteur adapté pourrait être un accéléromètre ou un capteur acoustique, tous deux configurés pour créer le signal courant en détectant les vibrations émises par la machine à surveiller.

Un troisième exemple est le contrôle non destructif de pipelines métalliques. Dans cette situation, un capteur adéquat est une sonde à courants de Foucault, laquelle est configurée pour générer le signal courant en mesurant l'épaisseur d'un pipeline en cours de surveillance.

**Revendications**

1. Procédé de détection d'anomalies au sein d'un environnement ou système, comportant les étapes suivantes :

   - acquérir (E1) un signal normal ($S_N$) reflétant l'état normal de l'environnement ou du système,
   - déterminer à partir du signal normal ($S_N$) une densité de probabilité $f$ qui modélise un état de comportement normal de l'environnement ou du système,
   - établir (E3) un filtre d'information en se basant sur ladite densité de probabilité $f$, ledit filtre d'information étant configuré pour converger vers une valeur limite $L$ lorsqu'il est appliqué sur des échantillons d'un signal normal, tout en augmentant sa valeur en réponse à la détection d'une anomalie,
   - établir (E4) une valeur seuil S basée sur ladite valeur limite de convergence,
   - acquérir (E5) un signal courant ($S_C$) reflétant l'état de comportement courant de l'environnement ou du système,
   - échantillonner (E6) ledit signal courant ($S_C$) en une série courante de N échantillons,
   - calculer (E7) un résultat de l'application du filtre d'information sur ladite série courante de N échantillons,
   - comparer (E8) ledit résultat avec ladite valeur seuil $S$, une anomalie étant détectée si ledit résultat excède ladite valeur seuil.

2. Procédé selon la revendication 1, **caractérisé en ce que** ladite valeur seuil $S$ est égale à ladite valeur limite $L$, majorée d'une valeur $\varepsilon$ de majoration choisie en fonction d'un compromis recherché entre une détection fiable et une minimisation du nombre de fausses alarmes.

3. Procédé selon la revendication 1 ou 2, **caractérisé en ce que** le filtre d'information correspond à un premier filtre conçu de telle sorte que, lorsqu'il est appliqué sur des échantillons d'un signal normal, il converge vers une valeur limite qui correspond à l'entropie de la densité de probabilité associée à ce signal normal.

4. Procédé selon la revendication 3, **caractérisé en ce que** l'application dudit premier filtre sur ladite série courante d'un nombre déterminé $N$ d'échantillons consiste à calculer le logarithme naturel de la valeur de la densité de probabilité $f$ pour chacun des échantillons $x_k$, à faire ensuite la sommation de ces logarithmes, et à multiplier le résultat de cette sommation par le facteur négatif correspondant à l'inverse dudit nombre déterminé $N$ d'échantillons, selon la formule suivante :

[Math. 6]

$$I_i = -\frac{1}{N} \sum_{x_k \in W_i} \log f(x_k)$$

5. Procédé selon la revendication 3 ou 4, **caractérisé en ce que** ladite valeur seuil $S$ est égale à la valeur de l'entropie $H$ ($f$) de la densité de probabilité $f$, majorée d'une valeur $\varepsilon$ comprise dans un intervalle allant de 1% à 20% de la valeur absolue de ladite entropie, selon la formule suivante :

[Math. 7]

$$S = H(f) + \varepsilon$$

6. Procédé selon la revendication 5, **caractérisé en ce que** ladite valeur de majoration est définie dans une fourchette comprise entre 10% et 20% de la valeur absolue de l'entropie, dans le but de parvenir à une probabilité très faible de fausses alarmes, comprise entre $10^{-4}$ et $10^{-3}$.

7. Procédé selon la revendication 5, **caractérisé en ce que** ladite valeur de majoration est définie dans une fourchette comprise entre 1% et 10% de la valeur absolue de l'entropie, pour favoriser l'atteinte d'une fiabilité maximale dans la détection d'anomalie.

8. Procédé selon la revendication 1, **caractérisé en ce que** le filtre d'information correspond à un deuxième filtre qui s'appuie sur ledit premier filtre décrit dans les revendications 3 ou 4, et utilise une fonction continue qui représente une approximation de la densité de probabilité de données du signal courant ($S_C$) sur une fenêtre glissante $W_i$ prédéterminée.

9. Procédé selon la revendication 8, **caractérisé en ce que** l'application dudit deuxième filtre sur ladite série courante d'un nombre déterminé N d'échantillons consiste à calculer le logarithme naturel de la valeur de la fonction continue pour chacun des échantillons, calculer la moyenne des résultats obtenus pour ces logarithmes naturels, et d'ajouter le résultat de ladite moyenne au résultat de l'application du premier filtre sur la même série courante d'échantillons, selon la formule suivante :

[Math. 8]

$$K_i = \frac{1}{N} \sum_{x_k \in W_i} \log g(x_k) + I_i$$

10. Dispositif de détection d'anomalies au sein d'un environnement ou système, comportant :

- un module d'acquisition (3) configuré pour acquérir un signal courant reflétant l'état de comportement courant de l'environnement ou du système,
- un processeur (5) configuré pour :
- échantillonner ledit signal courant en une série courante de N échantillons,
- calculer un résultat de l'application d'un filtre d'information sur ladite série courante de N échantillons, ledit filtre d'information étant basé sur une densité de probabilité modélisant un état de comportement normal de l'environnement ou du système, ledit filtre d'information étant configuré pour converger vers une valeur limite lorsqu'il est appliqué sur des échantillons d'un signal normal, tout en augmentant sa valeur en réponse à la détection d'une anomalie,
- comparer ledit résultat avec une valeur seuil basée sur ladite valeur limite de convergence, une anomalie étant détectée si ledit résultat excède ladite valeur seuil, et
- une interface de sortie (9) configuré pour indiquer la détection d'une anomalie.

11. Dispositif de détection selon la revendication 10, **caractérisé en ce qu'**il comporte un magnétomètre (11) configuré pour générer ledit signal courant en captant un champ magnétique ambiant, comprenant le champ terrestre ainsi que diverses perturbations magnétiques.

12. Dispositif de détection selon la revendication 10, **caractérisé en ce qu'**il comporte un accéléromètre configuré pour générer le signal courant en captant les vibrations émanant d'une machine à surveiller.

13. Dispositif de détection selon la revendication 10, **caractérisé en ce qu'**il comporte un compteur configuré pour générer le signal courant en mesurant le volume de données échangées au niveau d'un nœud spécifique d'un réseau informatique à surveiller.

14. Dispositif de détection selon la revendication 10, **caractérisé en ce qu'**il comporte une sonde à courant de Foucault configurée pour produire le signal courant en mesurant l'épaisseur d'un pipeline sous surveillance.

[Fig. 1]

FIG. 1

[Fig. 2]

$S_N$ — E1

$S_N \rightarrow f$ — E2

$F(f,g,N)$

$F(S_N) \rightarrow L$

$F(A) \nearrow$

— E3

$S = \alpha L + \varepsilon$ — E4

$S_C$ — E5

$S_C \rightarrow W_i$ — E6

$F(W_i)$ — E7

$F(W_i) \overset{?}{\gtrless} S$ — E8

# FIG. 2

[Fig. 3]

$S_N$ — E11

$S_N \rightarrow f$ — E12

$I_i(f, N)$

$I_i(S_N) \rightarrow H(f)$

$I_i(A) \nearrow$ — E13

$S = H(f) + \varepsilon$ — E14

$S_C$ — E15

$S_C \rightarrow W_i$ — E16

$I(W_i)$ — E17

$I(W_i)) \gtrless S$ — E18

# FIG. 3

[Fig. 4A]

Signal utilisé pour modéliser
le comportement normal

FIG. 4A

[Fig. 4B]

100 bins, delta_x=9,78e-13
H=-sum(f(x)*log(f(x))*dx = -23,7695, H true=-23799

FIG. 4B

[Fig. 5A]

FIG. 5A

[Fig. 5B]

FIG. 5B

[Fig. 5C]

FIG. 5C

[Fig. 5D]

FIG. 5D

[Fig. 5E]

FIG. 5E

[Fig. 5F]

FIG. 5F

[Fig. 6]

FIG. 6

Europäisches
Patentamt

European
Patent Office

Office européen
des brevets

# RAPPORT DE RECHERCHE EUROPEENNE

Numéro de la demande

EP 25 18 1451

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | QIAO SHUAI ET AL: "Adaptive filter entropy monitoring method for scalar magnetic detection using optically pumped magnetometers", MEASUREMENT SCIENCE AND TECHNOLOGY, IOP, BRISTOL, GB, vol. 34, no. 5, 15 février 2023 (2023-02-15), XP020456684, ISSN: 0957-0233, DOI: 10.1088/1361-6501/ACB608 [extrait le 2023-02-15] | 1-11,13, 14 | INV. G01V3/08 |
| Y | * abrégé * * page 2 - page 3; figures 1,5 * ----- | 12 | |
| Y | US 2017/031049 A1 (DAUGELA DARCY [CA]) 2 février 2017 (2017-02-02) * alinéas [0008], [0027], [0033] * ----- | 12 | |
| A,D | ARIE SHEINKER ET AL: "Magnetic anomaly detection using entropy filter", MEASUREMENT SCIENCE AND TECHNOLOGY, IOP, BRISTOL, GB, vol. 19, no. 4, 1 avril 2008 (2008-04-01), page 45205, XP020136190, ISSN: 0957-0233 * page 1 - page 3 * ----- | 1-14 | DOMAINES TECHNIQUES RECHERCHES (IPC) G01V |
| A | FAN LIMING ET AL: "Adaptive Magnetic Anomaly Detection Method Using Support Vector Machine", IEEE GEOSCIENCE AND REMOTE SENSING LETTERS, IEEE, USA, vol. 19, 2 octobre 2020 (2020-10-02), pages 1-5, XP011895684, ISSN: 1545-598X, DOI: 10.1109/LGRS.2020.3025572 [extrait le 2021-12-29] * page 3 - page 5 * ----- -/-- | 1-14 | |

Le présent rapport a été établi pour toutes les revendications

| Lieu de la recherche | Date d'achèvement de la recherche | Examinateur |
|---|---|---|
| La Haye | 24 octobre 2025 | Lorne, Benoît |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

page 1 de 2

Europäisches
Patentamt

European
Patent Office

Office européen
des brevets

**RAPPORT DE RECHERCHE EUROPEENNE**

Numéro de la demande

EP 25 18 1451

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | TSURIEL RAM-COHEN ET AL: "Characterization and detection of oscillating magnetic dipole signals", MEASUREMENT SCIENCE AND TECHNOLOGY, IOP, BRISTOL, GB, vol. 28, no. 4, 16 février 2017 (2017-02-16), page 45104, XP020314785, ISSN: 0957-0233, DOI: 10.1088/1361-6501/AA59C0 [extrait le 2017-02-16] * page 4 *<br><br>----- | 1-14 | |
| | | | **DOMAINES TECHNIQUES RECHERCHES (IPC)** |

Le présent rapport a été établi pour toutes les revendications

| Lieu de la recherche | Date d'achèvement de la recherche | Examinateur |
|---|---|---|
| La Haye | 24 octobre 2025 | Lorne, Benoît |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

page 2 de 2

## ANNEXE AU RAPPORT DE RECHERCHE EUROPEENNE
## RELATIF A LA DEMANDE DE BREVET EUROPEEN NO.

EP 25 18 1451

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

24-10-2025

| Document brevet cité au rapport de recherche | Date de publication | Membre(s) de la famille de brevet(s) | Date de publication |
|---|---|---|---|
| US 2017031049 A1 | 02-02-2017 | CA 2932064 A1 | 02-12-2016 |
| | | EP 3475691 A1 | 01-05-2019 |
| | | US 2017031049 A1 | 02-02-2017 |
| | | WO 2017205958 A1 | 07-12-2017 |

EPO FORM P0460

Pour tout renseignement concernant cette annexe : voir Journal Officiel de l'Office européen des brevets, No.12/82

**EP 4 664 160 A1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **SHEINKER et al.** Magnetic Anomaly Detection Using an Entropy Filter. *Measurement Science and Technology*, vol. 19 (045205), https://doi.org/10.1088/0957-0233/19/4/045205

- **ZHOU et al.** Magnetic anomaly detection via a combination approach of minimum entropy and gradient orthogonal functions. *ISA Transactions*, vol. 134, 548-560, https://doi.org/10.1016/j.isatra.2022.08.026